# FASCICULE DE BREVET EUROPEEN

(11) **EP 1 256 961 B1**
(45) Date de publication et mention de la délivrance du brevet: **28.03.2007**
(21) Numéro de dépôt: 02291142.4
(22) Date de dépôt: 06.05.2002
(51) Int. Cl.: G11C 16/04

(54) **Architecture de mémoire non volatile et circuit intégré comportant une mémoire correspondante**
Nichtflüchtige Speicherarchitektur und integrierte Schaltung mit diesem Speicher
Nonvolatile memory architecture and integrated circuit comprising such a memory

(30) Priorité: 07.05.2001 FR 0106091
(43) Date de publication de la demande: 13.11.2002
(73) Titulaire: STMicroelectronics S.A., 92120 Montrouge (FR)
(72) Inventeur: Dray, Cyrille, 92593 Levallois-Perret Cedex (FR); Fournel, Richard, 92593 Levallois-Perret Cedex (FR); Thomas, Sigrid, 92593 Levallois-Perret Cedex (FR)
(74) Mandataire: Bentz, Jean-Paul

(56) Documents cités:
- US-A- 5 185 718
- US-A- 5 400 276
- US-A- 5 517 044

## Description

La présente invention concerne une architecture de mémoire non volatile et un circuit intégré correspondant.

Elle s'applique notamment aux mémoires non volatiles de type EPROM, EEPROM, Flash EPROM.

De façon générale, il faut comprendre par cellule mémoire non volatile un élément apte à mémoriser un état électrique, et comprenant une grille de commande et deux électrodes de canal. Un exemple typique de cellule mémoire non volatile comprend un transistor MOS à grille flottante. On connaît d'autres types de cellules mémoire non volatile, comme par exemple des cellules mémoire ferro-magnétiques.

Dans la suite, et pour la clarté de l'exposé, on prend l'exemple de cellules mémoire à transistor MOS à grille flottante. Les deux électrodes sont alors typiquement le drain et la source du transistor. Le rôle de ces électrodes peut être inversé.

Dans ce contexte, le document de brevet US 5,400,276 présente une architecture de mémoire non volatile organisée en mots selon une matrice de rangées et de colonnes, avec un transistor de sélection pour chaque mot, connecté à une des électrodes du transistor et chacune des cellules constituant le mot.

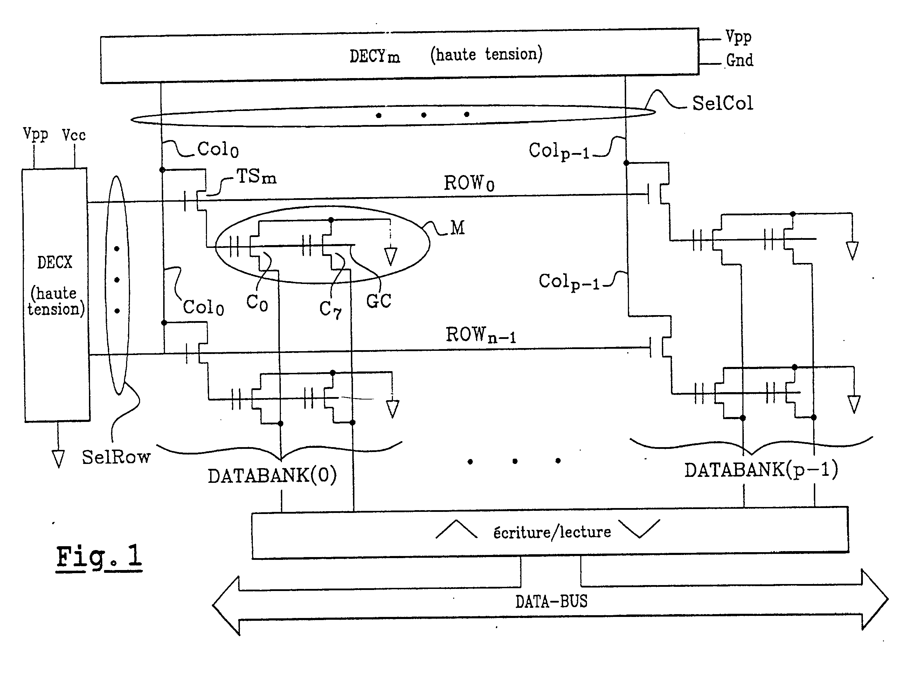

La figure 1 illustre également un exemple de réalisation connue d'une mémoire non volatile organisée par banques de données DATABANK(0) DATABANK(p-1) selon une matrice de rangées Row₀ à Rowₙ₋₁ et de colonnes Col₀ à Colₚ₋₁. Dans cet exemple, chaque mot regroupe plusieurs cellules mémoire sur une même rangée, et comprend un transistor de sélection connecté à la rangée et à la colonne correspondante. Les grilles de commande des cellules d'un mot sont connectées en commun. Et leurs drains (ou leurs sources) sont connectées à des lignes de bit respectives. Chaque ligne de bit connecte tous les drains (ou toutes les sources) des cellules de même rang dans une colonne. C'est sur ces grilles de commande et ces drains que doivent être appliqués les niveaux de haute tension nécessaires à la programmation des cellules.

Selon l'état de la technique, la sélection d'un mot dans une banque de la matrice se fait aussi par la grille de contrôle commune aux grilles de commande des cellules mémoire du mot, et par leurs drains (ou leurs sources) qui forment les lignes de bit.

Ainsi, dans ces architectures, les fonctions de sélection et de commutation de haute tension sont liées. Pour ces raisons, les décodeurs de rangée et de colonne doivent intégrer des circuits de commutation de haute tension , un par colonne et un par rangée. Des circuits de commutation associés aux lignes de bit doivent aussi être prévus. Ces commutateurs sont coûteux et très encombrants.

En outre, en ce qui concerne la lecture d'un mot mémoire, on rappelle qu'il est habituellement nécessaire de prévoir une phase de précharge des lignes de bit. Le terme "précharge" est à prendre dans le sens général, signifiant une charge ou une décharge de ces lignes, selon la technologie mémoire envisagée. Or on a vu que dans l'état de la technique, les lignes de bit participent de la sélection des cellules mémoire. On ne peut donc appliquer cette phase de précharge qu'aux lignes de bit correspondant au mot sélectionné. Il s'ensuit que si l'on veut lire successivement plusieurs mots en mémoire (multi-lecture), il faut relancer la phase de précharge pour chaque lecture. Ceci est très pénalisant sur le plan de la vitesse de lecture.

Un objet de l'invention est une nouvelle architecture mémoire qui n'a pas les inconvénients précités. Notamment, un objet de l'invention est une architecture mémoire dans laquelle le nombre de circuits de commutation haute tension est diminué.

Un autre objet de l'invention est d'améliorer le temps d'accès en lecture des mémoires, c'est à dire le temps au bout duquel la donnée reflétant l'état mémorisé dans une ou des cellules mémoire est disponible en sortie.

L'idée à la base de l'invention, est une architecture par mot dans laquelle la fonction de sélection d'un mot est dissociée de la fonction de commutation de la haute tension sur les cellules mémoire, et plus généralement, de la fonction d'application des niveaux de tension sur les cellules mémoire, correspondant à l'opération à réaliser : lecture ou programmation.

Selon l'invention, la sélection du mot n'est pas assurée par la grille de commande des cellules ni par les lignes de bit qui connectent le drain de ces cellules. Ainsi, selon l'invention, l'application d'une haute tension sur le drain et la grille de commande d'une cellule mémoire n'est pas suffisant à sélectionner cette cellule en programmation. Plus généralement, l'application des niveaux de polarisation de lecture ou de programmation sur les grilles et les drains de cellules de la mémoire, n'est pas suffisant pour sélectionner ces cellules en lecture ou en programmation.

L'idée à la base de l'invention est d'utiliser l'électrode de canal qui n'est pas connectée aux lignes de bit. En général, il s'agit de la source. Mais les fonctions source/drain peuvent être inversées dans certaines architectures mémoire.

Ainsi, selon l'invention, si l'on est en présence d'une architecture mémoire dans laquelle les drains sont les électrodes de canal reliées aux lignes de bit, alors on associe à chaque mot mémoire, un transistor de sélection de mot par la source des cellules. Ce transistor de sélection par la source est commandé par les signaux basse tension de sélection d'adresse fournis par les décodeurs d'adresse de la mémoire (décodeur de rangée et décodeur de colonne). On entend par niveau logique basse tension un niveau de tension inférieur ou égal à la tension d'alimentation logique Vcc du circuit intégré. Ce niveau est fonction de la technologie considérée. Par exemple, ce niveau peut être égal à Vcc ou à 2/3 de Vcc.

En d'autres termes, on applique directement les signaux de sortie des décodeurs sur les transistors de sélection.

La fonction des circuits de commutation de haute tension n'est donc plus d'appliquer la haute tension en sélectionnant le mot adressé en écriture, mais seulement d'appliquer la haute tension au moins sur le mot sélectionné par d'autres circuits.

Comme les lignes de bit et les grille de commande ne participent plus de la sélection de mot, il devient possible de regrouper des lignes de bit entre elles et des grilles de contrôle entre elles, pour les faire commander en haute tension par le même circuit de commutation. Chaque circuit de commutation peut ainsi commander plusieurs lignes de bit ou grilles de contrôle mises en commun. On réduit ainsi de façon non négligeable le nombre de circuits de commutation haute tension.

Notamment, on peut regrouper les lignes de bit de même rang de deux colonnes de mot distinctes et/ou les grilles de contrôle de deux rangées distinctes. L'application de la haute tension sur la ligne de bit ou la grille de contrôle d'une colonne non sélectionnée, n'affectera pas les cellules mémoire associées, leur source étant à un potentiel flottant (transistor de sélection non sélectionné, non passant).

En outre, comme les lignes de bit ne sont plus sur le chemin de sélection des cellules, il devient possible de lancer la phase de précharge des lignes de bit pour la lecture de mots en mémoire pour toutes les lignes de bit en même temps. Chaque cycle de lecture proprement dit ne comprend donc plus de phase de précharge. Cette dernière est en quelque sorte sortie du cycle de lecture pour être réalisée avant, une seule fois. En multi-lecture, on améliore ainsi sensiblement la vitesse d'accès de la mémoire.

L'invention concerne donc une architecture d'une mémoire non volatile organisée en mots selon une matrice de rangées et de colonnes, la sélection d'un mot de la matrice étant assurée par des signaux de sélection d'une rangée et d'une colonne fournis par des décodeurs d'adresse, chaque mot regroupant plusieurs cellules mémoire sur une même rangée et chaque cellule comprenant un transistor MOS à effet mémoire, avec une grille de commande, une première électrode de canal et une deuxième électrode de canal, les grilles de commande des cellules de chaque rangée de la mémoire étant connectées en commun à une ligne de grille de contrôle, la première électrode de chaque cellule étant connectée à une ligne de bit respective, caractérisée en ce que chaque mot comprend un transistor de sélection dudit mot par la deuxième électrode de chacune de ses cellules, commandé par lesdits signaux de sélection d'adresse basse-tension fournis en sortie par les décodeurs.

L'invention concerne aussi un circuit intégré comprenant une mémoire non volatile avec une telle architecture.

D'autres caractéristiques et avantages de l'invention sont détaillés dans la description suivante, faite à titre indicatif et non limitatif de l'invention et en référence aux dessins annexés dans lesquels :
- la figure 1 déjà décrite est un schéma général d'un exemple de réalisation d'une architecture d'une mémoire non volatile organisée par mot selon l'état de la technique.
- la figure 2 est un schéma général d'un exemple de réalisation d'une architecture mémoire selon l'invention, mettant en évidence la séparation entre les circuits de sélection de cellules mémoire et les circuits de commutation haute tension sur les cellules mémoire;
- la figure 3 un schéma détaillé d'un exemple de réalisation d'une telle architecture mémoire selon l'invention; et
- la figure 4 représente schématiquement un exemple de réalisation d'une circuiterie de lecture associée à un groupe de deux lignes de bit dans une architecture selon l'invention.

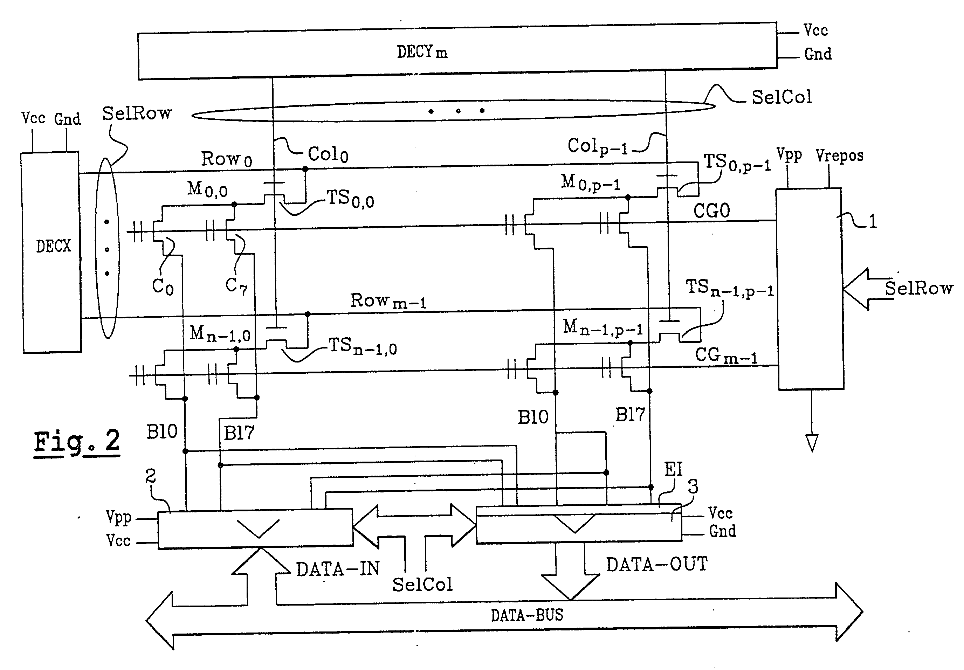

La figure 2 représente un exemple de réalisation d'une architecture mémoire non volatile organisée par mots selon l'invention, selon une matrice de n rangées Row₀ à Rowₙ₋₁ et p colonnes Col₀ à Colₚ₋₁ (n, p entiers). Dans cette architecture, le transistor MOS à effet mémoire de chaque cellule est un transistor à grille flottante, avec une grille de commande et deux électrodes de canal, drain et source.

Chaque mot mémoire regroupe k cellules sur la même rangée. Dans un exemple typique et comme représenté sur la figure 2, on a k=8. Chaque mot mémoire comprend alors huit cellules C0 à C7.

Chaque mot mémoire est connecté à une rangée et à une colonne de mot par un transistor de sélection associé. Chaque mot mémoire comprend ainsi k cellules mémoire et un transistor de sélection de mot associé. Par exemple le mot M_{0,0}, est connecté à la rangée Row₀, et à la colonne de mot Col₀, par le transistor de sélection TS_{0,0} associé.

Dans l'exemple d'architecture représenté sur la figure 2, on a choisit le cas typique dans lequel l'électrode de canal reliée aux lignes de bit de la mémoire est le drain. Le transistor de sélection de chaque mot est ainsi connecté à l'autre électrode, soit la source dans l'exemple, des cellules mémoire formant ce mot. Dans la suite, et pour la simplicité de l'exposé, on se réfère à l'exemple représenté. On parle donc de sélection de mot par la source ou de commutation de la haute tension sur les drains des cellules. L'homme du métier saura appliquer l'enseignement de la présente invention aux architectures dans lesquelles c'est la source qui est l'électrode de canal connectée aux lignes de bit.

Le décodage d'une adresse mémoire et la sélection d'un mot correspondant dans la matrice sont ainsi assurés directement par les signaux de sélection basse tension SelCol et SelRow délivrés en sortie des décodeurs de colonne DECYm et de rangée DECX. Ces signaux sont ainsi directement appliqués sur les transistors de sélection de la matrice. Dans l'exemple, chaque transistor de sélection a ainsi sa grille de contrôle commandée par un signal de sélection de colonne correspondant et son drain commandé par un signal de sélection de rangée correspondant. Par exemple, le transistor de sélection TS_{0,0} du mot mémoire M_{0,0} reçoit respectivement sur sa grille et sur sa source, le signal de sélection de colonne SelCol₀ et le signal de sélection de rangée SelRow₀.

Ainsi, dans une telle architecture, chaque rangée de la matrice est formée par la ligne de source commune des transistors de sélection de cette rangée et chaque colonne est formée par la ligne de grille commune des transistors de sélection de mot de cette colonne.

La structure d'un mot mémoire selon l'invention consiste elle en une source commune aux cellules de chaque mot, avec une sélection du mot par cette source commune. Chaque cellule mémoire a son drain connecté à une ligne de bit du plan mémoire. Sa grille de contrôle est commune avec celles des cellules de toute la rangée, formant une ligne de grille de contrôle. La source de chaque cellule mémoire est connectée au transistor de sélection du mot associé. Dans l'exemple, elles sont connectées au drain du transistor de sélection associé. Par exemple, les cellules mémoire C0, C1, ...C7 du mot mémoire M_{0,0} ont chacune leur drain connecté à une ligne de bit respective, B10, B11,... B17, tandis que leurs sources sont reliées en commun et commandées par le transistor de sélection associé TS_{0,0}, et leurs grilles sont connectées à (formées par) la ligne de grille de contrôle CG0.

Dans cette architecture on a donc, en parallèle de chaque rangée de la mémoire, une ligne de grille de contrôle commune des cellules de cette rangée. Ces lignes de grilles de contrôle CG₀, ...CGₙ₋₁ de la matrice sont commandées par un circuit 1 de commande de polarisation. Ce circuit reçoit en entrées les signaux logiques de sélection de rangées SelRow₀,.., SelRowₙ₋₁ fournis par le décodeur de rangées DECX. Il applique sur chaque ligne de grille de contrôle une tension de polarisation correspondant à l'opération à effectuer : soit la haute tension Vpp soit une tension de repos, Vrepos.

Comme ces lignes de grille de contrôle ne sont plus sur le chemin de la sélection des cellules mémoire, elles peuvent être regroupées, par exemple deux à deux. Chaque groupe de ligne de grille de contrôle est alors commandé par un seul circuit de commutation haute tension du circuit 1 de polarisation. Si on groupe les lignes deux par deux, on divise de moitié le nombre de circuits de commutation haute tension nécessaire.

En pratique, si on suppose qu'une rangée Rowi est sélectionnée en programmation, le groupe de lignes de grille de contrôle auquel appartient la ligne de grille de contrôle CGi associée à la rangée sélectionnée Rowᵢ reçoit la haute tension de programmation. Et les lignes de grille de contrôle de tous les autres groupes reçoivent la tension de repos.

Cette tension de repos est appliquée aux lignes de tous les groupes si l'opération pour laquelle une rangée a été sélectionnée est une opération de lecture, ou si il n'y a pas d'opération en cours.

Le niveau de la tension de repos est typiquement égal ou inférieur au niveau de la tension d'alimentation logique Vcc. On verra plus loin qu'il est avantageux de prendre comme niveau de tension de repos le niveau de tension de polarisation en lecture.

De la même façon qu'avec les lignes de grille de contrôle, il est possible de regrouper les lignes de bit. Dans l'exemple, la matrice comprend p colonnes (ou banque de données) et n rangées. La matrice comprend donc p groupes de lignes de bit. Chaque groupe comprend autant de lignes de bit que de cellules dans un mot, soit dans l'exemple k=8 lignes de bit B10 à B17.

Ces groupes de lignes de bit B10-B17 sont connectées d'une part, à un circuit de programmation 2 qui reçoit la donnée à programmer DATA-IN et d'autre part à un circuit de lecture 3 qui fournit en sortie la donnée lue DATA-OUT.

Le circuit 2 de programmation comprend des circuits de commutation haute tension pour appliquer la haute tension Vpp ou la masse Gnd sur au moins un groupe de lignes de bit, en fonction de la donnée DATA-IN à programmer appliquée en entrée.

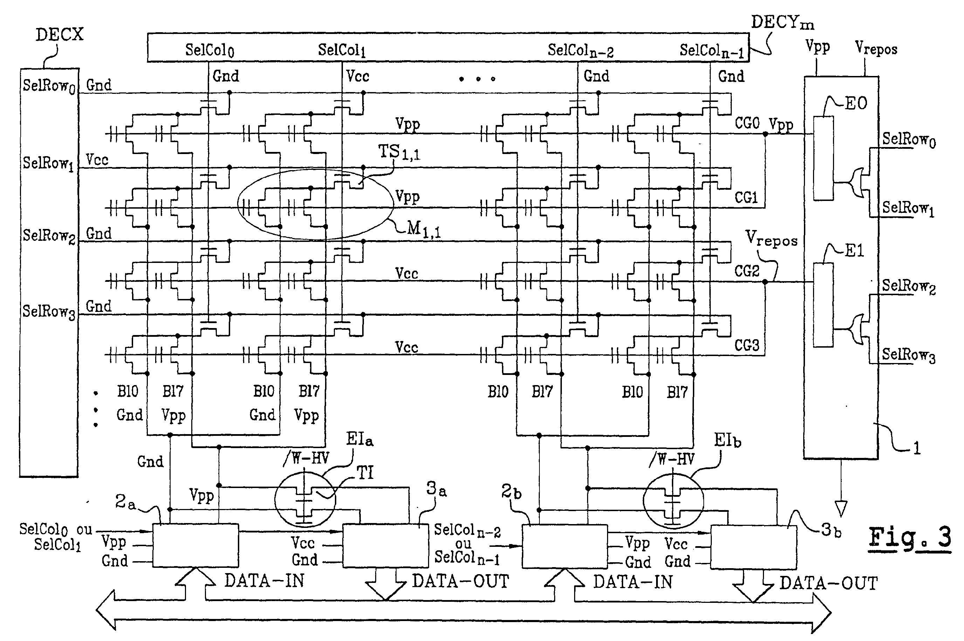

De préférence, on partage chacun des circuits de commutation avec au moins deux groupes de lignes de bit. De cette façon on divise par deux le nombre de circuits de commutation de haute tension nécessaire. Ce faisant, on réalise un gain de place très important. Cet aspect de l'invention sera expliqué plus en détail en relation avec la figure 3.

Le circuit 3 de lecture comprend typiquement des circuits de précharge des lignes de bit et des circuits détection comprenant les amplificateurs différentiels, par lesquels l'état des cellules du mot sélectionné en lecture est transmis en sortie de donnée DATA-OUT.

Comme on le verra également en relation avec la figure 3, le regroupement des lignes de bit est applicable de façon semblable qu'avec le circuit 2 de programmation.

Dans chacun des circuits de programmation 2 et de lecture 3, un seul étage est activé en même temps, correspondant à la sélection de colonne (ou banque de donnée) effectuée. Ainsi, l'information de sélection de colonne SelCol est appliquée en entrée de ces deux circuits.

S'agissant du circuit de lecture, ce signal de sélection de colonne n'est de préférence appliqué que pour la sélection du circuit de détection lui-même associé à la colonne sélectionnée en lecture. Ainsi, en dehors des opérations d'écriture, les circuits de précharge peuvent être activés avant même le début d'un cycle de lecture. En d'autres termes, on sort le temps de précharge des lignes de bit du cycle de lecture. Ceci est particulièrement avantageux en mode multi-lecture dans lequel plusieurs opérations de lecture sont réalisées successivement.

De même, lorsqu'aucune opération de programmation n'est en cours, on a vu que par défaut, le circuit 1 de polarisation des lignes de grille de contrôle porte toutes ces lignes à une tension de repos, indépendamment de la sélection de rangée effectuée. De préférence, le niveau de cette tension de repos est égal au niveau de tension de lecture à appliquer sur les grilles de commande des cellules mémoire en mode de lecture. Ainsi, si une opération de lecture est reçue, les grilles de commandes sont déjà polarisées à la bonne tension. On gagne ainsi le temps de précharge de ces grilles capacitives. Ceci est rendu possible parce que la sélection des cellules mémoire ne se fait plus par leurs grilles.

De cette façon, supposons que l'on lise successivement tous les mots d'une rangée de la mémoire, on a alors une phase de précharge commune à tous les groupes de ligne de bit, (en dehors de toute sélection), puis des cycles successifs de lecture, dans lesquels il n'y a que le circuit de détection qui change, selon le groupe de lignes de bit sélectionné pour chaque cycle : la durée du cycle de lecture devient égale à la durée de sélection du circuit de détection et de la détection proprement dite.

Sur la figure 2, on a en outre représenté un étage EI d'isolation en entrée du circuit 3 de lecture. Il est en effet préférable d'empêcher que la haute tension appliquée sur les lignes de bit par le circuit 2 de programmation puisse affecter le circuit 3 de lecture lors des opération de programmation. Comme détaillé sur la figure 3, sur laquelle on a représenté deux circuits de lecture 3a et 3b associés respectivement aux groupes de lignes de bit B10-B17 des colonnes Col₀ et Col₁ pour le circuit 3a et des colonnes Colₚ₋₂ et Colₚ₋₁ pour le circuit 3b, un étage d'isolation associé EIa, EIb, comprend en pratique un transistor d'isolation TI par lignes de bit mises en commun. Ces transistors sont commandés par le même signal haute tension de programmation noté /W-HV. L'ensemble des transistors d'isolation est commandé par le même signal de commande, ce qui nécessite donc un unique circuit de commutation haute tension supplémentaire pour fournir ce signal de commande, à partir du signal W de commande de programmation.

La figure 3 montre plus particulièrement un exemple de regroupement de lignes de bit et de grilles de contrôle que peut permettre une architecture mémoire selon l'invention, en détaillant les quatre premières rangées Row₀ à Row₃ de la matrice et les deux premières colonnes Col₀ et Col₁ et les deux dernières colonnes Colₙ₋₂, Colₙ₋₁ de la matrice. Dans cet exemple, on a un regroupement de lignes de bit par deux colonnes adjacentes et un regroupement des lignes de grille de contrôle par deux rangées adjacentes. Ainsi, les lignes B10 des colonnes Col₀ et Col₁ sont connectées ensemble, les lignes B11 de ces deux colonnes sont connectées ensemble, et ainsi de suite jusqu'aux lignes B17 de ces deux colonnes qui sont reliées ensemble. De même, les lignes de grille de contrôle CG0 et CG1 des rangées Row₀ et Row₁ sont connectées ensemble, les lignes de grille de contrôle CG2 et CG3 sont reliées ensemble, et ainsi de suite pour tout le plan mémoire.

Les lignes de grille de contrôle regroupées sont commandées par le même circuit de commutation haute tension du circuit 1 de polarisation. Le circuit de commutation haute tension associé à chaque groupe de lignes de grille de contrôle est commandé par un circuit logique qui reçoit en entrées chacun des signaux de sélection de rangée correspondant aux lignes du groupe concerné. Ainsi, dans l'exemple représenté, le circuit de commutation haute tension E0 commande le groupe des lignes de grille de contrôle CG0 et CG1. La commande de commutation de ce circuit E0 est fournie par un circuit logique, une porte OU dans l'exemple, qui reçoit en entrées les signaux de sélection des rangées SelRow₀ et SelRow₁.

En pratique, la limite supérieure du nombre de lignes de grille de contrôle que l'on puisse regrouper selon l'invention est fonction de la taille mémoire et de la capacité équivalente résultante. Il faut faire en effet un compromis entre le gain en surface, le temps de charge de cette capacité et le stress induit, pour amener les lignes de grille de contrôle regroupées, du niveau de la tension de repos au niveau de la haute tension Vpp.

En ce qui concerne les lignes de bit, on peut faire deux remarques. La première, est que l'on peut réserver le regroupement de lignes de bit uniquement au circuit 2 de programmation. Il faut alors prévoir un transistor de court-circuit entre les lignes de bit à mettre en commun, pour n'activer cette configuration qu'en mode de programmation (non représenté). Ces transistors seraient commandés de façon complémentaire par rapport aux transistors d'isolation TI prévus en entrée du circuit de lecture. Cette variante ne génère donc pas de circuit de commutation supplémentaire.

La deuxième remarque est que, dans le cas où l'on appliquerait le regroupement de lignes de bit également au circuit de lecture, le générateur de courant de précharge devra être dimensionné de façon adaptée : si on a deux lignes de bit à précharger en commun par le même circuit, pour ne pas ralentir la précharge, il faudra que ce circuit de précharge fournisse deux fois le courant de précharge habituel.

Le choix du nombre de lignes de bit regroupées est là aussi déterminé en pratique en fonction des compromis possibles entre temps de précharge et quantité de courant injectable (dimensions des transistors).

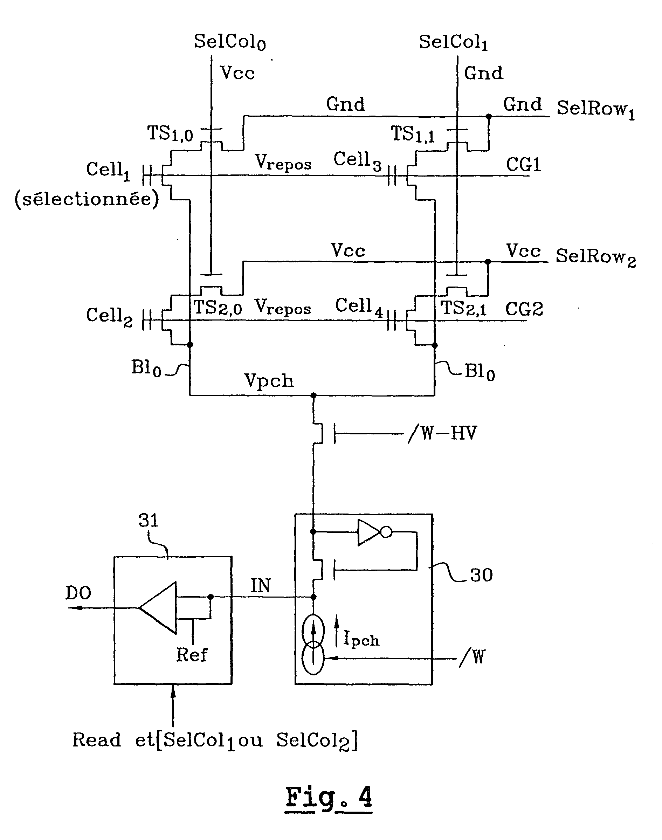

En ce qui concerne le mode de fonctionnement d'une telle architecture, on se réfère à la figure 4, pour le fonctionnement en lecture.

Sur cette figure on a représenté les cellules connectées aux lignes de bit B10 de deux colonnes adjacentes Col0 et Col1 et deux rangées adjacentes Row1 et Row2. Dans l'exemple, la ligne de bit B10 de la colonne Col0 et celle de la colonne Col1 sont mises en commun selon le principe de l'invention.

Sur la colonne Col₀ on a ainsi une première cellule Cell1, sur la rangée Row_{1,} et une deuxième cellule Cell2 sur la rangée Row₂. Sur la colonne Col₁ on a ainsi une première cellule Cell3, sur la rangée Row₁, et une deuxième cellule Cell4 sur la rangée Row₂.

Si on a une opération de lecture sur le mot défini par Col₀, Row₁, la cellule Cell1 est notamment sélectionnée en lecture par les signaux de sélection SelCol0 et SelRow1 appliqués sur le transistor de sélection associé TS_{1,0}.

Les lignes de bit B10 des colonnes Col₀ et Col₁ sont préchargées par le même circuit de précharge 30 du circuit de lecture, à une tension de précharge identique Vpch, par injection d'un courant Ipch et par l'action de la boucle de contre-réaction CIV du circuit de précharge, connecté entre les deux lignes de bit BL0 mises en commun et l'entrée IN de l'amplificateur du circuit de détection 31 associé.

Les grilles de contrôle CG1 et CG2 des rangées Row₁ et Row₂ sont déjà polarisées à la tension de repos, que l'on a pris de préférence égale à la tension de polarisation en lecture, par le circuit 1 de commande de polarisation.

Dans la suite on suppose que les deux niveaux logiques basse-tension sont Gnd et Vcc. On a vu que le niveau logique haut pouvait avoir un niveau inférieur à Vcc, par exemple être égal à 2/3 de Vcc, selon la technologie mémoire envisagée. L'homme du métier saura appliquer ce qui suit aux différentes technologies.

Le décodeur de colonne impose Vcc sur la colonne Col₀ sélectionnée (SelCol0=1), et Gnd sur les autres colonnes.

Le décodeur de rangée impose Gnd sur la rangée sélectionnée Row₁(SelRow1=0) et met les autres rangées en haute impédance.

Ainsi, seule la cellule Cell1 peut conduire, selon son état. Les autres cellules ne peuvent pas conduire. En effet, les transistors de sélection associés aux cellules Cell2, Cell3 et Cell4 ne conduisent aucun courant : ils laissent donc le potentiel de source de ces cellules à l'état flottant.

En pratique, on notera que toutes les lignes de bit de la matrice sont préchargées à Vpch, en dehors de toute sélection en lecture.

Le fonctionnement en programmation est expliqué en référence à la figure 3.

Si on a une opération de programmation d'une donnée DATA-IN sur le mot M1 défini par Col₁, Row₁, les cellules de ce mot sont sélectionnées en programmation. Les autres cellules de cette architecture ne sont nullement affectées par les niveaux de tension de programmation appliquées.

En effet, la rangée Row₁ étant sélectionnée, le circuit 1 de commutation applique la haute tension sur les lignes de grilles CG0 et CG1 qui sont regroupées. Les autres grilles, comme les grilles CG2 et CG3, sont à Vcc par défaut.

La colonne Col₁ étant sélectionnée, la haute tension de programmation ou la masse sont appliquées sur les lignes de bit B10 à B17 des colonnes Col₀ et Col₁, les lignes de bit de ces colonnes étant regroupées deux à deux. Le niveau appliqué sur chacune dépend de la donnée DATA-IN à programmer. Dans l'exemple, les lignes de bit BL0 des deux colonnes sont toutes deux amenées à GND, correspondant à un bit D0 de donnée d'entrée à "0", et les lignes de bit B17 des deux colonnes sont portées à Vpp, correspondant à un bit de donnée d'entrée D7 à "1".

Seule la colonne Col₁ étant sélectionnée, on retrouve Vcc sur la grille des transistors de sélection de cette colonne et Gnd sur toutes les autres grilles.

Seule la rangée Row1 étant sélectionnée, on retrouve Vcc (ou Vcc+Vt) sur la source des transistors de sélection de cette rangée et Gnd sur toutes les autres.

Ainsi, seul le transistor de sélection TS_{1,1} associé au mot M_{1,1} est passant et tire la source des cellules du mot mémoire à la masse, ce qui déclenche la programmation par électrons chauds des cellules dont le drain (la ligne de bit) est à Vpp, la grille de contrôle étant par ailleurs elle-même à Vpp.

Les autres cellules ont leur source à un potentiel flottant.

Les autres cellules de la matrice ne sont pas stressées car aucune n'a à supporter une trop grande différence de potentiel à ses bornes, qu'elle se situe sur une colonne sélectionnée ou non, ou sur une rangée sélectionnée ou non, comme il apparaît sur la figure 3 ou les niveaux de tension des différents éléments ont été indiqués.

Dans l'exemple plus particulièrement détaillé, on a décrit une opération d'écriture de la mémoire correspondant à une programmation. L'invention s'applique aussi dans le cas d'une opération écriture correspondant à un effacement. En ce qui concerne la possibilité d'effacer électriquement des cellules mémoire avec une telle architecture, il convient de noter que cet effacement ne peut être obtenu que par application d'une haute tension sur la source, ce qui n'est pas nécessairement compatible avec toutes les technologies de cellules mémoire non volatile. On peut aussi envisager l'application de la haute tension par la prise de caisson/substrat des transistors formant ces cellules.

L'architecture mémoire selon l'invention qui vient d'être décrite dans un mode de réalisation particulier permet donc l'utilisation de moins de circuits de commutation haute tension, et permet d'améliorer le temps d'accès en lecture. Elle est applicable à toutes les technologies de mémoire non volatile. Elle s'étend aux architectures dans lesquelles les fonctions source/drain des cellules mémoire sont inversées.

## Revendications

1. Mémoire non volatile organisée en mots selon une matrice de rangées et de colonnes, la sélection d'un mot de la matrice étant assurée par des signaux de sélection d'une rangée (SelRow) et d'une colonne (Selcol) fournis par des décodeurs d'adresse (DECX, DECYm), chaque mot (M_{0,0}) regroupant plusieurs cellules mémoire (C0, ...,C7) sur une même rangée et chaque cellule comprenant un transistor MOS à effet mémoire, avec une grille de commande, une première électrode de canal et une deuxième électrode de canal, les grilles de commande des cellules de chaque rangée (Row₀) de la mémoire étant connectées en commun à une ligne de grille de contrôle (CG0), la première électrode dudit transistor Mos de chaque cellule étant connectée à une ligne de bit respective, chaque mot comprenant un transistor de sélection dudit mot (TS_{0,0}) connecté à la deuxième électrode dudit transistor Mos de chacune de ses cellules, **caractérisé en ce que** ledit transistor de sélection est commandé par lesdits signaux de sélection d'adresse basse-tension (SelCol, SelRow) fournis en sortie par les décodeurs, lesdits signaux de sélection d'adresse ayant un niveau de tension inférieur ou égal à la tension d'alimentation logique (V_{cc}) de la mémoire.

2. Mémoire selon la revendication 1, **caractérisée en ce qu'**elle comprend une ligne de grille de contrôle (CG0) par rangée de la mémoire, les lignes de grille de contrôle étant commandées par un circuit de polarisation (1) recevant en entrées, les signaux de sélection d'adresse.

3. Mémoire selon la revendication 2, **caractérisée en ce que** les lignes de grille de contrôle (CG0, CG1, ...) sont regroupées au moins deux à deux, chaque groupe de lignes de grille de contrôle étant commandé par un circuit de commutation haute tension (E0) du circuit de polarisation (1) recevant en entrées les signaux de sélection correspondant aux lignes de grille de contrôle du groupe.

4. Mémoire selon la revendication 3, **caractérisée en ce que** les lignes de grille de contrôle mises en commun (CG0, CG1) correspondent à des rangées adjacentes (Row0, Row1).

5. Mémoire selon la revendication 3 ou 4, **caractérisée en ce que** ledit circuit de commutation haute tension applique en sortie sur la ligne de grille de contrôle ou sur le groupe de lignes de contrôle associé, soit la haute tension Vpp, pour une commande d'écriture sur une rangée sélectionnée correspondant à la dite ligne ou à une ligne dudit groupe, ou une tension de repos (Vrepos).

6. Mémoire selon la revendications 5, **caractérisée en ce que** la dite tension de repos est appliquée en sortie par les circuits de commutation haute tension en dehors de toute opération d'écriture.

7. Mémoire selon la revendication 5 ou 6, **caractérisée en ce que** le niveau de ladite tension de repos est choisi égal au niveau de tension de polarisation des grilles des cellules en mode de lecture.

8. Mémoire selon l'une des revendications 1 à 7, chaque colonne de la mémoire comprenant un groupe de lignes de bit (B10-B17), une ligne par bit de donnée à écrire (DATA-IN) ou à lire (DATA-OUT), **caractérisée en ce que** les lignes de bit de même rang (B10) d'au moins deux colonnes (Col₀, Col₁) sont connectées en commun.

9. Mémoire selon la revendication 8, **caractérisée en ce que** les colonnes dont les lignes de bit de même rang (B10) sont regroupées, sont adjacentes (Col0, Col1).

10. Mémoire selon l'une quelconque des revendications 8 ou 9, un circuit de lecture (3) comprenant un circuit de précharge de lecture associé à un circuit de détection à amplificateurs différentiels fournissant la donnée lue (DATA-OUT) en sortie, **caractérisée en ce que** ledit circuit de précharge reçoit une commande d'activation avant le début d'un cycle ou d'une succession de cycles de lecture.

11. Mémoire selon la revendication 10, **caractérisée en ce que** le circuit de précharge amène toutes les lignes de bit de la mémoire à la même tension de précharge (Vpch).

12. Mémoire selon la revendication 10 ou 11, **caractérisée en ce qu'**il comprend un circuit d'isolation (EI) entre les lignes de bit et ledit circuit de lecture (3), ledit circuit d'isolation étant activé (/W-HV) pendant les opérations d'écriture.

13. Circuit intégré comprenant une mémoire non volatile selon l'une quelconque des revendications précédentes.

## Claims

1. Non-volatile memory organized in words according to a matrix of rows and columns, a word of the matrix being selected by row-selection (SelRow) and column-selection (SelCol) signals given by address decoders (DECX, DECYm), each word (M_{0,0}) grouping together several memory cells (C0, ..., C7) in one same row and each cell comprising a memory effect MOS transistor with a control gate, a first channel electrode and a second channel electrode, the control gates of the cells of each row (Row₀) of the memory being connected in common to a control gate line (CG0), the first electrode of said MOS transistor of each cell being connected to a respective bit line, each word comprising a transistor for the selection of said word (TS_{0,0}) connected to the second electrode of said MOS transistor of each of its cells, **characterized in that** said selection transistor is controlled by said low-voltage address selection signals (SelCol, SelRow) given at output by the decoders, said address selection signals having a voltage level lower than or equal to the logic supply voltage (Vcc) of the memory.

2. Memory according to claim 1, **characterized in that** it comprises one control gate line (CG0) per row of the memory, the control gate lines being controlled by a bias circuit (1) receiving the address selection signals as inputs.

3. Memory according to claim 2, **characterized in that** the control gate lines (CG0, CG1, ...) are grouped together at least two by two, each group of control gate lines being controlled by a high-voltage switching circuit (E0) of the bias circuit (1) receiving, at inputs, the selection signals corresponding to the control gate lines of the group.

4. Memory according to claim 3, **characterized in that** the pooled control gate lines (CG0, CG1) correspond to adjacent rows (Row0, Row1).

5. Memory according to claim 3 or 4, **characterized in that** said high-voltage switching circuit applies, at output to the control gate line or to the associated group of control lines, either the high voltage Vpp, for a write command to a selected row corresponding to said line or to a line of said group, or an idle voltage (Vrepos).

6. Memory according to claims 5, **characterized in that** said idle voltage is applied at output by the high voltage switching circuits without there being any write operation.

7. Memory according to claim 5 or 6, **characterized in that** the level of said idle voltage is chosen to be equal to the level of the bias voltage for the gates of the cells in read mode.

8. Memory according to one of claims 1 to 7, each column of the memory comprising a group of bit lines (B10-B17), one line per data bit to be written (DATA-IN) or read (DATA-OUT), **characterized in that** the same-ranking bit lines (B10) of at least two columns (Col₀, Col₁) are connected in common.

9. Memory according to claim 8, **characterized in that** the columns whose same-ranking bit lines (B10) are grouped together are adjacent (Col₀, Col₁).

10. Memory according to any of claims 8 or 9, a read circuit (3) comprising a read precharging circuit associated with a detection circuit with differential amplifiers giving the data (DATA-OUT) read at output, **characterized in that** said precharging circuit receives an activation command before the start of a read cycle or a succession of read cycles.

11. Memory according to claim 10, **characterized in that** the precharging circuit takes all the bit lines of the memory to the same precharging voltage (Vpch).

12. Memory according to claim 10 or 11, **characterized in that** it comprises an isolation circuit (EI) between the bit lines and said read circuit (3), said isolation circuit being activated (/W-HV) during the write operations.

13. An integrated circuit comprising a non-volatile memory according to any of the preceding claims.

## Patentansprüche

1. Nicht flüchtiger Speicher, der in einer Matrix aus Zeilen und Spalten wortorganisiert ist, wobei die Auswahl eines Wortes der Matrix durch Auswahlsignale einer Zeile (SelRow) und einer Spalte (SelCol) sichergestellt ist, die durch Adressdekoder (DECX, DECYm) bereitgestellt werden, wobei jedes Wort (M_{0,0}) mehrere Speicherzellen (C0, ..., C7) in ein und derselben Zeile umgruppiert und jede Zelle einen MOS-Transistor mit Speicherwirkung umfasst, mit einer Gate-Schaltung, einer ersten Kanal-Elektrode und einer zweiten Kanal-Elektrode, wobei die Gate-Schaltungen der Zellen jeder Zeile (Row₀) des Speichers gemeinsam an eine Gate-Steuerleitung (CG0) angeschlossen sind, wobei die erste Elektrode des MOS-Transistors jeder Zelle an eine jeweilige Bitleitung angeschlossen ist, wobei jedes Wort einen Auswahl-Transistor des Wortes (TS_{0,0}) aufweist, der an die zweite Elektrode des MOS-Transistors jeder seiner Zellen angeschlossen ist, **dadurch gekennzeichnet, dass** der Auswahl-Transistor durch die Adress-Auswahlsignale niedriger Spannung (SelCol, SelRow) gesteuert wird, die von den Dekodern am Ausgang bereitgestellt werden, wobei die Adress-Auswahlsignale einen Spannungspegel von kleiner oder gleich der Logik-Versorgungsspannung (Vcc) des Speichers haben.

2. Speicher nach Anspruch 1, **dadurch gekennzeichnet, dass** dieser eine Gate-Steuerleitung (CG0) pro Zeile des Speichers umfasst, wobei die Gate-Steuerleitungen durch eine Polarisationsschaltung (1) gesteuert werden, die an ihren Eingängen die Adress-Auswahlsignale empfängt.

3. Speicher nach Anspruch 2, **dadurch gekennzeichnet, dass** die Gate-Steuerleitungen (CG0, CG1, ...) wenigstens paarweise umgruppiert werden, wobei jede Gruppe von Gate-Steuerleitungen durch einen Hochspannungs-Schaltkreis (E0) der Polarisationsschaltung (1) gesteuert wird, der an den Eingängen die den Gate-Steuerleitungen der Gruppe entsprechenden Auswahlsignale empfängt.

4. Speicher nach Anspruch 3, **dadurch gekennzeichnet, dass** die zusammengefassten Gate-Steuerleitungen (CG0, CG1) aneinander grenzenden Zeilen (Row0, Row1) entsprechen.

5. Speicher nach Anspruch 3 oder 4, **dadurch gekennzeichnet, dass** der Hochspannungs-Schaltkreis am Ausgang auf der Gate-Steuerleitung oder auf der zugeordneten Gruppe von Steuerleitungen anliegt, sei es die Hochspannung Vpp für einen Schreibbefehl auf eine der Leitung oder einer Leitung der Gruppe entsprechenden ausgewählten Zeile oder eine Ruhespannung (Vrepos).

6. Speicher nach Anspruch 5, **dadurch gekennzeichnet, dass** die Ruhespannung am Ausgang durch die Hochspannungs-Schaltkreise außerhalb jeglicher Schreiboperation anliegt.

7. Speicher nach Anspruch 5 oder 6, **dadurch gekennzeichnet, dass** der Pegel der Ruhespannung gleich dem Pegel der Polarisationsspannung der Gates der Zellen im Lesemodus gewählt ist.

8. Speicher nach einem der Ansprüche 1 bis 7, wobei jede Spalte des Speichers eine Gruppe von Bitzeilen (B10 bis B 17) aufweist, und zwar eine Leitung pro Schreib (DATA-IN)- oder Lese (DATA-OUT)-Datenbit, **dadurch gekennzeichnet, dass** die Bitleitungen ein und desselben Ranges (B 10) von wenigstens zwei Spalten (Col₀, Col₁) zusammengeschaltet sind.

9. Speicher nach Anspruch 8, **dadurch gekennzeichnet, dass** die Spalten, deren Bitleitungen ein und desselben Ranges (B 10) umgruppiert werden, aneinander grenzen (Col₀, Col₁).

10. Speicher nach einem der Ansprüche 8 oder 9, wobei eine Leseschaltung (3) eine Vorlast-Leseschaltung umfasst, die einer Detektionsschaltung mit unterschiedlichen Verstärkern zugeordnet ist, die den Lesewert (DATA-OUT) am Ausgang bereitstellt, **dadurch gekennzeichnet, dass** die Vorlastschaltung einen Aktivierungsbefehl vor dem Beginn eines Zyklus oder einer Aufeinanderfolge von Lesezyklen empfängt.

11. Speicher nach Anspruch 10, **dadurch gekennzeichnet, dass** die Vorlastschaltung alle Bitleitungen des Speichers auf die gleiche Vorlastspannung (Vpch) bringt.

12. Speicher nach Anspruch 10 oder 11, **dadurch gekennzeichnet, dass** dieser eine Isolierschaltung (EI) zwischen den Bitleitungen und der Leseschaltung (9) umfasst, wobei die Isolierschaltung während der Schreiboperationen aktiviert (/W-HV) ist.

13. Integrierter Schaltkreis mit einem nicht flüchtigen Speicher nach einem der vorstehenden Ansprüche.
